(19) **Europäisches Patentamt / European Patent Office / Office européen des brevets**

(11) **EP 2 040 307 B1**

(12) **EUROPEAN PATENT SPECIFICATION**

(45) Date of publication and mention
of the grant of the patent:
**07.08.2013 Bulletin 2013/32**

(51) Int Cl.:
*H01L 31/107* (2006.01) *H01L 31/0296* (2006.01)

(21) Application number: **07301386.4**

(22) Date of filing: **20.09.2007**

(54) **A photodetector for an optical device**

Fotodetektor für eine optische Vorrichtung

Photodétecteur pour dispositif optique

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**25.03.2009 Bulletin 2009/13**

(73) Proprietor: **Alcatel Lucent**
**75007 Paris (FR)**

(72) Inventor: **Achouche, Mohand**
**92120 Montrouge (FR)**

(74) Representative: **Shamsaei Far, Hassan et al**
**Alcatel-Lucent International**
**32, avenue Kléber**
**92700 Colombes (FR)**

(56) References cited:
**US-A- 5 121 181    US-A1- 2003 047 752**

- **ROGALSKI A: "Quantum well photoconductors in infrared detector technology" JOURNAL OF APPLIED PHYSICS, AMERICAN INSTITUTE OF PHYSICS. NEW YORK, US, vol. 93, no. 8, 15 April 2003 (2003-04-15), pages 4355-4391, XP012059396 ISSN: 0021-8979**
- **PAN J L ET AL: "Theory, fabrication and characterization of quantum well infrared photodetectors" MATERIALS SCIENCE AND ENGINEERING R: REPORTS, ELSEVIER SEQUOIA S.A., LAUSANNE, CH, vol. 28, no. 3-4, July 2000 (2000-07), pages 65-147, XP004201221 ISSN: 0927-796X**

**Description**

The present invention relates to a photodetector for an optical device for use in applications such as DWDM optical transmission and free space optics (FSO). Other applications may include NIR (Near Infra-Red) remote sensing spectroscopy for chemical analysis and satellites or security-type applications such as night visions, homeland security, and the like.

BACKGROUND OF THE INVENTION

Photodetectors operating at a wavelength range from 1.6 $\mu$m to 2.6 $\mu$m at room temperature are being increasingly used in applications such as DWDM optical transmission at L-U/XL bands (up to 1.7 $\mu$m) and free space optics (FSO) systems for last mile cable-free high capacity connectivity for carrier applications where optimum overall performances are usually achieved in the 2.0-2.5 $\mu$m range (so-called atmospheric transmission window). Conventional photodetectors for this wavelength range are known to be made by using two main types of material systems: HgCdTe and InGaAs.

HgCdTe photodetectors wavelength range can be tuned between 1 to 14 $\mu$m, which is a wide range for the applications identified above, depending on composition ratio of HgTe and CdTe. However, this technology suffers from the drawback that devices made based on HgCdTe generate excessive dark current, thus requiring an additional cooling mechanism in order to achieve good capability for photo-detection. However, the addition of a cooling mechanism is detrimental as it complicates the manufacturing of the device.

The expression "dark current", in this context, refers to an electric current generated inside the photodetector device without the presence of photons, which is an undesirable effect in the photodetector, the expression being known to those skilled in the related art.

As regard use of InGaAs material, photodiodes made with the known lattice-matched $In_xGa_{(1-x)}As$ (x=0.53) grown on an InP substrate can be tailored so as to achieve a spectral bandwidth edge in a range between 1.65 $\mu$m and 2.6 $\mu$m, the range being obtainable by varying the x fraction in the alloy. However, here again a high dark current is generated due to a lattice-mismatched InAsP buffer layer which produces dislocations, *i.e.* crystalline defects, with the associated drawbacks.

A further solution is based on the use of $In_{0.83}Ga_{0.17}As$ multiple quantum wells, strain-compensated by $In_{0.83}Ga_{0.17}P$ barrier layers. This solution allows to extend the cut-off wavelength up to 1.9 $\mu$m using inter-band transition. However, a large number of quantum well periods (in the order of 100 quantum wells) become necessary in order to achieve a good detector responsivity.

The term "responsivity", in this context, refers to the ratio between the electrical output to the optical input of the device, the term being known to those skilled in the related art.

A still further solution is based on the use of dual-band transition in InGaAs/InP quantum wells, namely intra-band and inter-band transition.

The term "intra-band" refers to a type of transition in which an electron excited by an incident photon is made to move from a first level to a second level, the two levels being inside one single band, be it valence band or conduction band. The term "inter-band" in turn refers to the transition of an electron excited by an incident photon from a first level to a second level, where each of said levels is in a different band, for example a transition from the valence band to the conduction band or vice-versa. Both these terms are known to those skilled in the related art. However, the material properties of these quantum wells allow only transitions at wavelength of 1.1 $\mu$m in NIR and 9 $\mu$m in MIR (MIR standing for Mid-Infra-Red). Therefore by using this technique, the desired range of 1.6 $\mu$m to 2.6 $\mu$m is not covered. In addition, devices manufactured using this technique suffer from excessive leakage currents, thus requiring the photodetector to operate at only very low temperatures (typically around 77K).

A still further known solution relates to photodetectors based on the use of type II inter-band transition in GaInAs/GaAsSb quantum wells. For this type of photodetectors, an operation wavelength of 2.3 $\mu$m is known. However, in this case, despite a large number of quantum well pairs present in the device, the photodetector responsivity remains low because of the low efficiency of type II transitions in quantum wells.

It is therefore desired to provide a photodetector capable of operating at wavelengths in the range of 1.6 $\mu$m to 2.6 $\mu$m providing at the same time an improved level of responsivity as compared to the known devices, without suffering from the above-identified drawbacks.

US 2003/0047752 A1 describes an avalanche photodiode including a multiplication layer. The multiplication layer may include a well region and a barrier region. The well region may include a material having a higher carrier ionization probability than a material used to form the barrier region.

US-A- 5121181 describes a long wavelength detector which is formed by coupling a highly doped cathode to an anode through an undoped quantum well or superlattice filter structure. The absorption mechanism is free-carrier absorption in a heavily doped direct bandgap semiconductor (the cathode). The cathode material is preferably chosen such that the conduction band edge is lower than the conduction band edge of the material forming the well of the resonant-tunneling filter. The cathode material should also be semiconductor material of relatively narrow direct bandgap with low effective electron mass. The detector device is biased so that electrons pass through the filter structure by resonant tunneling. To stimulate conduction, incident radiation must have a frequency (i.e., photon energy) sufficient to boost the energy of the cathode electrons from the Fermi energy level of the cathode to the resonance energy level of the quantum-well filter. Thus, photons of incident radiation are absorbed in the cathode which may also be referred to as the photon absorber. In a second, voltage-tunable, embodiment a single quantum well filter having an undoped subband is disposed between a doped cathode and an anode structure. The single quantum well filter structure includes a quantum well with one or more subbands surrounded by two barrier regions. The detection frequency is changed by increasing or decreasing the bias slope of the conduction band which, in turn, moves the quantum well subband energy level relative to the cathode Fermi energy level.

DESCRIPTION OF THE INVENTION

The above objective is reached by using the solution proposed by the present invention according to which intra-band transition is used between quantized states within the conduction band in InAlAs/InGaAs quantum wells in order to achieve an absorption wavelength in the desired range of 1.6 $\mu$m to 2.6 $\mu$m. Furthermore, in order to increase the responsivity of the device, the invention proposes the multiplication of the photogenerated electrons in a separate avalanche layer based on a separate absorption and multiplication (SAM) structure. The terms "photogenerated electron" refer to electrons and holes generated by absorption of the incident light.

Accordingly one object of the present invention is that of providing a method for detecting wavelengths within a predefined range by a photodetector, comprising the step of performing a transition of electron energy by absorption of energy in response to an incident light, characterized by comprising the steps of:

- performing said transition in intra-band within a quantum well, between quantized levels in a conduction band; and
- performing multiplication of free electrons generated by said transition in an avalanche layer.

According to an aspect of the invention, said predefined range of wavelength is between about 1.6 $\mu$m and about 2.6 $\mu$m.

According to another aspect of the invention the wavelength is about 2.6 $\mu$m or about 2 $\mu$m.

According to still another aspect of the invention the photodetector is built on a separate absorption grading and multiplication avalanche photodiode.

According to a further aspect of the invention, intra-band photogenerated carriers move out of quantum wells, thus becoming free electrons which are the injected into the avalanche layer.

Another object of the present invention is that of providing a photodetector for detecting wavelengths within a predefined range, using electron energy transition by absorption of energy in response to an incident light, characterized in that the photodetector is adapted to perform said transition in intra-band within a quantum well, between quantized levels in a conduction band, and to perform multiplication of free electrons generated by said transition in an avalanche layer.

According to an aspect of the invention the photodetector is built on a separate absorption and multiplication avalanche photodiode.

Preferably the photodetector is built on a separate absorption grading and multiplication avalanche photodiode.

According to another aspect of the invention the quantum well of the photodetector has barrier layers, wherein the height and width of the barrier layers are selected so as to minimize a tunneling current.

Preferably said width of the barrier layers is between 6 and 8 nm, and more preferably about 7 nm.

Preferably said height of the barrier layers is between 0.5 eV and 0.9 eV.

According to still another aspect of the invention said predefined range of wavelength is between about 1.6 $\mu$m and about 2.6 $\mu$m.

According to yet another aspect of the invention the photodetector is further adapted to perform inter-band transition from an energy level in a valence band to an energy level in the conduction band.

According to a further aspect of the invention a doping level of the charge present in the avalanche region is $4 \times 10^{12}$ cm$^{-2}$.

According to still a further aspect of the invention the quantum well has a width of 4 nm and the wavelength is about 2 $\mu$m.

According to yet a further aspect of the invention the quantum well has a width of 4.5 nm and the wavelength is about 2.3 $\mu$m.

As a result of performing transition in intra-band between quantized states in a conduction band within a quantum well, an absorption at the predefined wavelength range is achieved.

Furthermore, the multiplication of photogenerated electrons in an avalanche layer improves responsivity.

These and further features and advantages of the present invention are described in more detail in the following description as well as in the claims with the aid of the accompanying drawings.

BRIEF DESCRIPTION OF THE DRAWINGS

Figure 1 is a schematic energy-band diagram of a single quantum well absorption layer.
Figure 2-a is a calculated energy band diagram of an SAGM APD with intra-band transition quantum wells absorption layer.

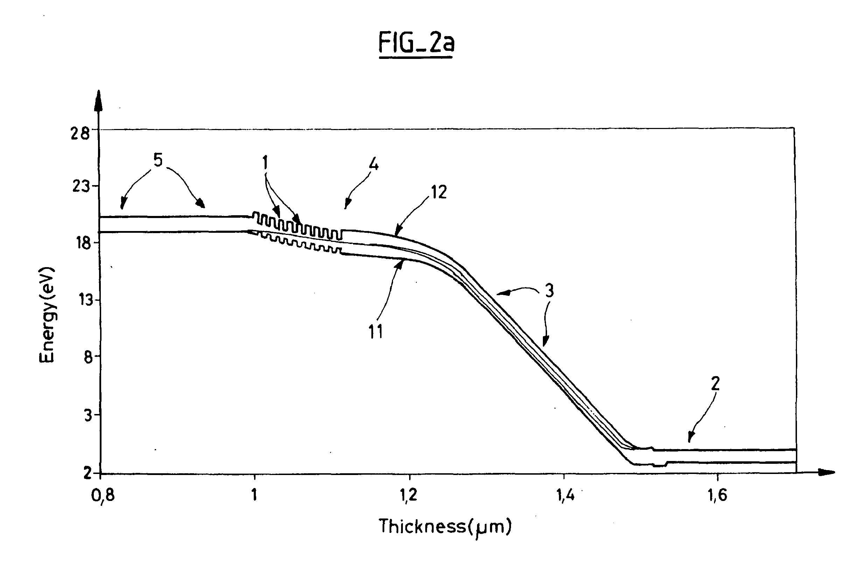

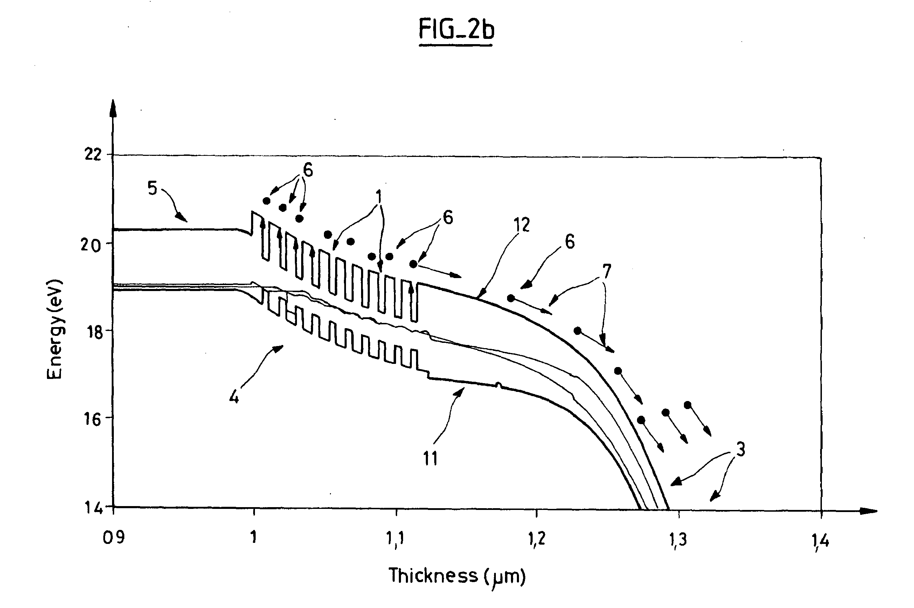

Figure 2-b is a representation in part of the diagram of figure 2-a showing in further detail intra-band photogenerated carriers in the quantum wells being injected into the avalanche layer.

EXAMPLES OF PREFERRED EMBODIMENTS

The device, according to the present invention is built on a separate absorption and multiplication (SAM) structure which is well-known in the art. Preferably, the device is built on the well known structure known as SAGM APD (SAGM standing for Separate Absorption Grading and Multiplication which is a specific variant of SAM with the particularity that in SAGM an additional layer is incorporated between absorption and multiplication with gradual composition which provides a gradual effect in the band-gap of the semi-conductor; APD standing for Avalanche Photodiode) where the absorption of incident light at the desired range of wavelengths is achieved by an intra-band transition in InAlAs/InGaAs quantum wells such as quantum well infrared photodetectors (QWIP). For known III-V type APDs, the structure is based on SAGM where multiplication and absorption take place in two different layers.

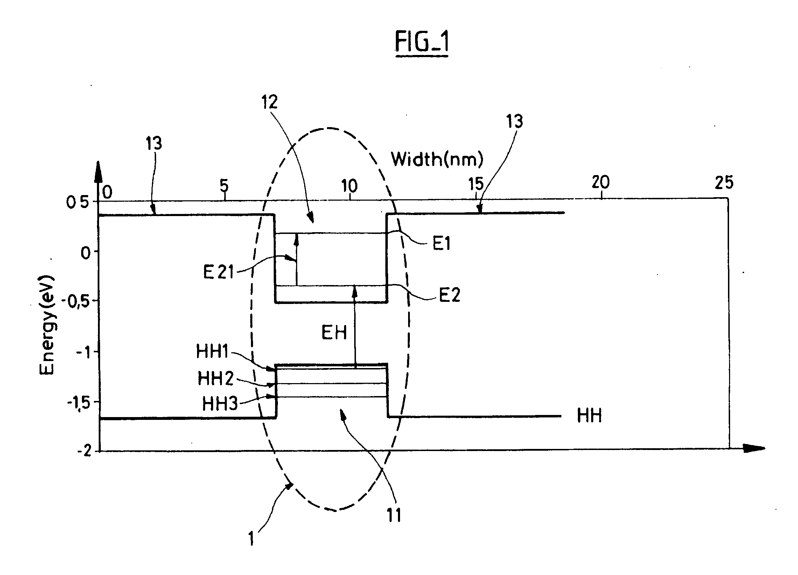

Figure 1 shows a schematic energy band diagram of a single quantum well 1 according to the present invention. The diagram is shown on a coordinate axes of Energy in eV on the Y axis and width of the device in nm on the X axis. As shown in the figure, the quantum well 1 has two energy levels, or bands, one being the valence band 11 and the other being the conduction band 12. In the figure only one quantum well is shown, however in practice further quantum wells adjacent to the one shown in the figure may exist, as will be observed in reference to figures 2-a and 2-b. In the case of multiple quantum wells, the quantum wells are separated from each other by means of the so-called barriers. A barrier corresponds to the bulk of the semiconductor located between two neighboring quantum wells. In figure 1, barrier levels are represented by reference numeral 13. The distance separating two neighboring quantum wells corresponds to the width of the barrier separating the quantum well.

In the present example, the quantum well 1 does not have a bias voltage applied thereto. The valence band 11 comprises energy levels shown in the figure by horizontal lines HH1, HH2 and HH3. The conduction band also comprises energy levels shown in the figure by horizontal lines E1 and E2. This is known in the related art.

According to the invention, upon the impact of an incident light, a bound-to-bound level transition of an electron occurs from a first energy level E1 to a second energy level E2 for an incident photon energy of E21, where:

$$E21 = E2 - E1.$$

In this manner the transition of the excited electron is performed within the conduction band, and thereby an intra-band transition is obtained. This transition is shown in figure 1 by the arrow E21.

In order to achieve one single transition E21 of interest with a corresponding wavelength within the desired range, for example 2.3 $\mu$m (E21 = 537 meV), the material composition and the width of the quantum well as well 1 as the those of the surrounding barrier(s) 13 are selected so as to provide optimum results. One preferred material composition for the quantum well is $In_{0.72}Ga_{0.28}As$. A preferred width for the quantum well is 4.5 nm with exx = -1.3% (exx standing for bi-axial strain and defined by the relationship exx=-$\Delta$a/a where a is the lattice-constant of the semi-conductor). A preferred material composition for the barrier is $In_{0.3}Al_{0.7}GaAs$ and a preferred width for the barrier is in the range of 6-8 nm, and preferably 7 nm with exx = +1.50%.

In a further example, a similar barrier width (7 nm) with exx= +1.5% is used, however with an $In_{0.72}Ga_{0.28}As$ quantum well having the width of 4 nm (with exx= -1.3%). In this case, a single E21 transition of 2.0 $\mu$m wavelength (E21 = 606 meV) is produced which is also in the desired range.

The photo-excited electrons, now in the E2 level, can therefore be swept out of the well by thermionic emission (thermally activated electrons) or by an applied voltage, resulting in free electrons which may then constitute a photocurrent, i.e. electric current generated as a result of a photon absorption.

The absorption region response time is very small as it is limited only by the photoelectron response time (no hole response time is associated with this transition).

Figure 1 shows also a possible inter-band transition, namely a transition between the valence band 11 and the conduction band 12. This is represented by the arrow EH showing a transition from the energy level HH1 in the valence band 11 to energy level E2 in the conduction band 12. The wavelength is typically 1.5 $\mu$m. This structure thus allows for providing a dual band photodetector operation using InAlAs/InGaAs material system.

In order to avoid or minimize tunneling effect, which is undesirable, appropriate height and width for the barrier layer 13 are selected. The preferred value of the width of the barrier level given above, i.e. in the range of 6-8 nm and preferably 7 nm, is also appropriate for this purpose. A preferred range for the height of the barrier level is between 0.5 eV to 0.9 eV.

In order to obtain an accurate electric field distribution along the detector structure, an appropriate doping level of the charge present in the avalanche region is to be selected. A typical value for an appropriate doping level of the charge in the avalanche region is $4\times10^{12}$ cm$^{-2}$. This prevents the presence of an excessive electric field in the absorption layer despite the fact that the quantum wells used are n-doped so as to provide free electrons which are confined in the well regions. Such characteristics allow to increase detector responsivity of incident light at wavelengths in the desired range m by multiplication gain without excessive dark current in the quantum well absorption layer.

Figure 2-a shows a calculated energy band diagram by simulation, with an applied bias of an SAGM APD with an absorption layer comprising ten quantum wells having the characteristics described above, and with intra-band transition at 2.3 $\mu$m. The diagram is shown on a coordinate axes of energy in eV on the Y axis and thickness of the device vertical structure in $\mu$m on the X axis. Starting from the substrate, on the bottom-right hand side of the diagram, the structure comprises an N-doped InAlAs contact layer 2, a non-intentionally-doped avalanche layer 3 of InAlAs material, a P-doped InAlAs charge layer (not shown), an InGaAlAs grading layer (not shown), followed by an absorption layer 4 comprising ten quantum wells 1 of InGaAs/InAlAs material (as described above) and a P-doped window layer 5 of InP material. The upper level energy line of the diagram, reference numeral 12, represents the conduction band energy level (in correspondence to figure 1) and the lower level energy line thereof, reference numeral 11, represent the valence band level (also in correspondence to figure 1).

Figure 2-b is a representation of a part of the diagram of figure 2-a showing in further detail the absorption layer 4 being located between the P-doped layer 5 and the avalanche layer 3. Like elements of this figure are given like reference numerals as those of figure 2-a.

According to the invention, intra-band photogenerated carriers 6 move out of the quantum wells 1 and become free electrons which are the injected into the avalanche layer 3. This is schematically represented in figure 2-b by means of arrows 7 showing the direction of displacement of the free electrons 6 towards the avalanche layer 3. The injection of the free electrons 6 in the avalanche layer allows for avalanche multiplication of the primary photocurrent, which improves the detector responsivity, to the extent that the responsivity is multiplied by a factor corresponding to the avalanche gain. Here, the primary photocurrent corresponds to the device photocurrent without avalanche gain, *i.e.* M=1, where M is the avalanche multiplication factor. The latter factor, in the case of avalanche multiplication obtained by the injection of the free electrons 6 may be within the following range: 1 <M<100.

In this manner a photodetector is obtained which is capable of operating at wavelengths in the range of 1.6 $\mu$m to 2.6 $\mu$m, providing at the same time improved responsivity due to the avalanche multiplication gain.

The SAGM structure with its field control layer (P-type charge layer) allows an accurate distribution of the electric field with a high electric field in the avalanche layer, as needed for impact ionization process, while the electric field in the absorption layer remains low, thus favoring multiplication gain without excessive dark current. In addition, as described above, an optimized selection of well and barrier widths contribute to preventing dark current tunneling with an electric field in the small energy band-gap quantum wells (InGaAs) remaining below 160 kV/cm.

The primary responsivity of the photodetector depends on the number of quantum wells and on their doping level because such doping provides the necessary free electrons for intra-band transition. Presently, SAGM APD with intra-band QWIP absorption layer allows up to 20 periods of InAlAs/InGaAs quantum wells, which is the same amount of InP/InGaAs quantum well periods currently known in the related art, where high responsivity was nevertheless achieved for the intra-band transition at 9 $\mu$m wavelength.

**Claims**

1.  Method for detecting wavelengths within a predefined range by a photodetector, comprising the step of performing a transition of electron energy by absorption of energy in response to an incident light, **characterized by** comprising the steps of:

    - performing said transition in intra-band within a quantum well (1), between quantized levels (E1, E2) in a conduction band (12); and
    - performing multiplication of free electrons (6) generated by said transition in an avalanche layer (3).

2.  A method according to claim 1, wherein said predefined range of wavelength is between about 1.6 $\mu$m and about 2.6 $\mu$m.

3.  A method according to claim 2, wherein the wavelength is about 2.6 $\mu$m.

4.  A method according to claim 2, wherein the wavelength is about 2 $\mu$m.

5.  A method according to any one of the preceding claims, wherein the photodetector is built on a separate absorption grading and multiplication avalanche photodiode.

6.  A method according to any one of the preceding claims, wherein intra-band photogenerated carriers (6) move out of quantum wells (1) thus becoming free electrons which are the injected into the avalanche layer (3).

7.  A photodetector for detecting wavelengths within a predefined range, using electron energy transition by absorption of energy in response to an incident light, **characterized in that** the photodetector is adapted to perform said transition in intra-band within a quantum well, between quantized levels (E1, E2) in a conduction band (12), and to perform multiplication of free electrons (6) generated by said transition in an avalanche layer (3).

8. A photodetector according to claim 7, wherein the photodetector is built on a separate absorption and multiplication avalanche photodiode.

9. A photodetector according to claim 8, wherein the photodetector is built on a separate absorption grading and multiplication avalanche photodiode.

10. A photodetector according to any one of claims 7 to 9, wherein the quantum well (1) of the photodetector has barrier layers, wherein the height and width of the barrier layers are selected so as to minimize a tunneling current.

11. A photodetector according to claim 10, wherein said width of the barrier layers is between 6 and 8 nm, preferably about 7 nm.

12. A photodetector according to claim 10 or claim 11, wherein said height of the barrier layers is between 0.5 eV and 0.9 eV.

13. A photodetector according to any one of the claims 7 to 12, wherein said predefined range of wavelength is between about 1.6 $\mu$m and about 2.6 $\mu$m.

14. A photodetector according to any one of the claims 7 to 13, wherein the photodetector is further adapted to perform inter-band transition from an energy level (HH1) in a valence band (11) to an energy level (E2) in the conduction band (12).

15. A photodetector according to any one of the claims 7 to 14, wherein a doping level of the charge present in the avalanche region is $4 \times 10^{12}$ cm-$^2$.

16. A photodetector according to claim 13, wherein the quantum well has a width of 4 nm and the wavelength is about 2 $\mu$m.

17. A photodetector according to claim 13, wherein the quantum well has a width of 4.5 nm and the wavelength is about 2.3 $\mu$m.

**Patentansprüche**

1. Verfahren zur Erkennung von Wellenlängen innerhalb eines vordefinierten Bereichs durch einen Photodetektor, umfassend den Schritt des Durchführens eines Elektronenenergieübergangs durch die Absorption von Energie in Reaktion auf ein einfallendes Licht, **dadurch gekennzeichnet, dass** es die folgenden Schritte umfasst:

- Durchführen des besagten Intra-Band-Übergangs innerhalb eines Quantentopfes (1) zwischen quantisierten Pegeln (E1, E2) in einem Leitungsband (12); und
- Durchführen einer Vervielfachung der durch den besagten Übergang erzeugten freien Elektronen (6) in einer Avalanche-Schicht (3).

2. Verfahren nach Anspruch 1, wobei der besagte vordefinierte Wellenlängenbereich zwischen etwa 1,6 $\mu$m und etwa 2,6 $\mu$m liegt.

3. Verfahren nach Anspruch 2, wobei die Wellenlänge etwa 2,6 $\mu$m beträgt.

4. Verfahren nach Anspruch 2, wobei die Wellenlänge etwa 2 $\mu$m beträgt.

5. Verfahren nach einem beliebigen der vorstehenden Ansprüche, wobei der Photodetektor auf einer separaten Absorptions-Grading- und Vervielfachungs-Avalanche-Photodiode aufgebaut ist.

6. Verfahren nach einem beliebigen der vorstehenden Ansprüche, wobei photogenerierte Intra-Band-Träger (6) die Quantentöpfe (1) verlassen und dadurch zu freien Elektronen werden, die in die Avalanche-Schicht (3) eingespeist werden.

7. Photodetektor zur Erkennung von Wellenlängern innerhalb eines vordefinierten Bereichs unter Verwendung des Elektronenenergieübergangs durch die Absorption von Energie in Reaktion auf ein einfallendes Licht, **dadurch gekennzeichnet, dass** der Photodetekor dazu ausgelegt ist, den besagten Intra-Band-Übergang innerhalb eines Quantentopfes zwischen quantisierten Pegeln (E1, E2) in einem Leitungsband (12) durchzuführen und die Vervielfachung der durch den besagten Übergang erzeugten freien Elektronen (6) in einer Avalanche-Schicht (3) durchzuführen.

8. Photodetektor nach Anspruch 7, wobei der Photodetektor auf einer separaten Absorptions- und Vervielfachungs-Avalanche-Photodiode aufgebaut ist.

9. Photodetektor nach Anspruch 8, wobei der Photodetektor auf einer separaten Absorptions-Grading- und Vervielfachungs-Avalanche-Photodiode aufgebaut ist.

10. Photodetektor nach einem beliebigen der Ansprüche 7 bis 9, wobei der Quantentopf (1) des Photodetektors Sperrschichten aufweist, wobei die Höhe und die Breite der Sperrschichten derart gewählt werden, dass ein Tunnelstrom minimiert wird.

11. Photodetektor nach Anspruch 10, wobei die besagte Breite der Sperrschichten zwischen 6 und 8 nm, vorzugsweise etwa 7 nm, beträgt.

12. Photodetektor nach Anspruch 10 oder Anspruch 11, wobei die besagte Höhe der Sperrschichten zwischen 0,5 eV und 0,9 eV beträgt.

13. Photodetektor nach einem beliebigen der Ansprüche 7 bis 12, wobei der vordefinierte Wellenlängenbereich zwischen etwa 1,6 $\mu$m und etwa 2,6 $\mu$m liegt.

14. Photodetektor nach einem beliebigen der Ansprüche 7 bis 13, wobei der Photodetektor weiterhin für das Durchführen des Inter-Band-Übergangs von einem Energieniveau (HH1) in einem Valenzband (11) zu einem Energieniveau (E2) in dem Leitungsband (12) ausgelegt ist.

15. Photodetektor nach einem beliebigen der Ansprüche 7 bis 14, wobei ein Dotierungsniveau der im Avalanche-Bereich vorhandenen Ladung 4x10$^{12}$ cm$^{-2}$ beträgt.

16. Photodetektor nach Anspruch 13, wobei der Quantentopf eine Breite von 4 nm und eine Wellenlänge von etwa 2 $\mu$m aufweist.

17. Photodetektor nach Anspruch 13, wobei der Quantentopf eine Breite von 4,5 nm und eine Wellenlänge von etwa 2,3 $\mu$m aufweist.


**Revendications**

1. Procédé de détection de longueurs d'onde dans une plage prédéfinie au moyen d'un photodétecteur, comprenant l'étape d'exécution d'une transition d'énergie d'électrons par absorption d'énergie en réponse à une lumière incidente, **caractérisé en ce qu'**il comprend les étapes suivantes :

   - effectuer ladite transition dans une intrabande à l'intérieur d'un puits quantique (1), entre des niveaux quantifiés (E1, E2) dans une bande de conduction (12) ; et
   - effectuer la multiplication d'électrons libres (6) générés par ladite transition dans une couche d'avalanche (3).

2. Procédé selon la revendication 1, dans lequel ladite plage de longueurs d'onde prédéfinie est comprise entre environ 1,6 $\mu$m et environ 2,6 $\mu$m.

3. Procédé selon la revendication 2, dans lequel la longueur d'onde est environ de 2,6 $\mu$m.

4. Procédé selon la revendication 2, dans lequel la longueur d'onde est environ de 2 $\mu$m.

5. Procédé selon l'une quelconque des revendications précédentes, dans lequel le photodétecteur est construit sur une photodiode à avalanche à absorption, gradient et multiplication séparés.

6. Procédé selon l'une quelconque des revendications précédentes, dans lequel des porteuses intrabande photogénérées (6) sont évacuées des puits quantiques (1) devenant ainsi des électrons libres qui sont injectés dans la couche d'avalanche (3).

7. Photodétecteur pour détecter des longueurs d'onde à l'intérieur d'une plage prédéfinie, en utilisant une transition d'énergie d'électrons par absorption d'énergie en réponse à une lumière incidente, **caractérisé en ce que** le photodétecteur est adapté pour effectuer ladite transition dans une intrabande à l'intérieur d'un puits quantique, entre des niveaux quantifiés (E1, E2) dans une bande de conduction (12), et pour effectuer la multiplication d'électrons libres (6) générés par ladite transition dans une couche d'avalanche (3).

8. Photodétecteur selon la revendication 7, dans lequel le photodétecteur est construit sur une photodiode à avalanche à absorption et multiplication séparées.

9. Photodétecteur selon la revendication 8, dans lequel le photodétecteur est construit sur une photodiode à avalanche à absorption, gradient et multiplication séparés.

10. Photodétecteur selon l'une quelconque des revendications 7 à 9, dans lequel le puits quantique (1) du photodétecteur présente des couches d'arrêt, dans lequel la hauteur et la largeur des couches d'arrêt sont choisies de sorte à réduire au minimum un courant tunnel.

11. Photodétecteur selon la revendication 10, dans lequel ladite largeur des couches d'arrêt est comprise entre 6 et 8 nm, et est de préférence environ de 7 nm.

12. Photodétecteur selon la revendication 10 ou la revendication 11, dans lequel ladite hauteur des couches d'arrêt est comprise entre environ 0,5 eV et 0,9 eV.

13. Photodétecteur selon l'une quelconque des revendications 7 à 12, dans lequel ladite plage de longueurs d'onde prédéfinie est comprise entre environ 1,6 $\mu$m et environ 2,6 $\mu$m.

14. Photodétecteur selon l'une quelconque des revendications 7 à 13, dans lequel le photodétecteur est en outre adapté pour effectuer une transition interbande entre un niveau d'énergie (HH1) dans une bande de valence (11) et un niveau d'énergie (E2) dans la bande de conduction (12).

**15.** Photodétecteur selon l'une quelconque des revendications 7 à 14, dans lequel un niveau de dopage de la charge présente dans la région d'avalanche est de $4 \times 10^{12}$ cm$^{-2}$.

**16.** Photodétecteur selon la revendication 13, dans lequel le puits quantique a une largeur de 4 nm et la longueur d'onde est environ de 2 $\mu$m.

**17.** Photodétecteur selon la revendication 13, dans lequel le puits quantique a une largeur de 4,5 nm et la longueur d'onde est environ de 2,3 $\mu$m.

FIG_1

## FIG_2a

EP 2 040 307 B1

FIG_2b

EP 2 040 307 B1

**EP 2 040 307 B1**

**Patent documents cited in the description**

- US 20030047752 A1
- US 5121181 A